# FASCICULE DE BREVET EUROPEEN

(11) **EP 4 430 927 B1**
(45) Date de publication et mention de la délivrance du brevet: **08.10.2025**
(21) Numéro de dépôt: 22813670.1
(22) Date de dépôt: 02.11.2022
(51) Int. Cl.: H05K 7/20, H01L 23/473, B64D 33/08, H01L 23/373, H01L 23/40

(54) **SYSTEME ELECTRIQUE A REFROIDISSEMENT PAR FLUIDE CALOPORTEUR, AERONEF COMPORTANT UN TEL SYSTEME ET PROCEDE DE FABRICATION D'UN TEL SYSTEME**
ELEKTRISCHES SYSTEM MIT KÜHLUNG DURCH WÄRMEÜBERTRAGUNGSFLÜSSIGKEIT, FLUGZEUG MIT SOLCH EINEM SYSTEM UND VERFAHREN ZUR HERSTELLUNG SOLCH EINES SYSTEMS
ELECTRICAL SYSTEM WITH COOLING BY HEAT-TRANSFER FLUID, AIRCRAFT COMPRISING SUCH A SYSTEM AND METHOD FOR MANUFACTURING SUCH A SYSTEM

(30) Priorité: 08.11.2021 FR 2111811
(43) Date de publication de la demande: 18.09.2024
(73) Titulaire: Safran, 75015 Paris (FR); Safran Electrical & Power, 31702 Blagnac Cedex (FR)
(72) Inventeur: YOUSSEF, Toni, 77550 MOISSY-CRAMAYEL (FR); MARTINEAU, Donatien Henri Edouard, 77550 MOISSY-CRAMAYEL (FR); GAUTIER, Cyrille, 77550 MOISSY-CRAMAYEL (FR); NEHME, Samir, 77550 MOISSY-CRAMAYEL (FR)
(74) Mandataire: Gevers & Orès
(86) Numéro de dépôt international: PCT/FR2022/052059
(87) Numéro de publication internationale: WO 2023/079236

(56) Documents cités:
- DE-A1- 10 039 770
- DE-A1- 102019 200 011
- US-A- 5 083 373

## Description

### Domaine technique de l'invention

La présente invention concerne un système électrique à refroidissement par liquide caloporteur et un procédé de fabrication d'un tel système.

### Arrière-plan technologique

Il est connu d'utiliser un radiateur muni de saillies de dissipation de chaleur pour refroidir un module électrique de puissance. La fixation du radiateur est par exemple réalisée par serrage mécanique, ou bien par brassage ou frittage. Le radiateur peut alors venir fermer un canal d'un système de refroidissement par fluide caloporteur, généralement un liquide comme de l'eau, de sorte que les saillies s'étendent dans le canal et soient refroidies par le contact du fluide circulant dans le canal.

Un problème de ces techniques de refroidissement est de nécessiter une purge du fluide caloporteur pour le montage et la maintenance du module de puissance.

Il peut ainsi être souhaité de prévoir un système électrique qui permette de s'affranchir d'au moins une partie des problèmes et contraintes précités.

Les documents DE 100 39 770 A1 et US 5,083,373 décrivent chacun un radiateur et une plaque froide présentant des formes complémentaires.

Le document DE 10 2019 200 011 A1 décrit un radiateur avec des ailettes.

### Résumé de l'invention

Il est donc proposé un système électrique d'un aéronef, comportant :
- un module électrique de puissance comportant un radiateur muni de saillies de dissipation thermique ; et
- une plaque froide d'une boîte à fluide caloporteur, présentant des cavités complémentaires des saillies pour recevoir ces dernières ;
caractérisé en ce que du métal liquide est intercalé entre le radiateur et la plaque froide, au moins entre les saillies et les cavités.

L'invention permet ainsi de facilement séparer le module de puissance de la boite à fluide caloporteur, du fait que le module de puissance est reçu sur la plaque froide et ne s'étend donc pas dans la boîte à fluide caloporteur. En outre, cette séparation facile est permise tout en maintenant de bonnes performances d'échange thermique grâce aux cavités prévues sur la plaque froide pour recevoir les saillies du radiateur.

Le métal liquide améliore l'échange thermique tout en facilitant son application. En effet, par son caractère liquide, il se répand naturellement dans l'interstice entre le radiateur et la plaque froide, malgré sa forme biscornue du fait de l'imbrication des saillies dans les cavités,

De façon optionnelle, le métal liquide présente une conductivité thermique supérieure à 50 W/m·K. Ainsi, un bon échange thermique peut être obtenu.

De façon optionnelle également, le métal liquide reste liquide entre -20°C et 150°C. Ainsi, le métal liquide est bien adapté à l'environnement d'un aéronef, dans lequel les températures de cette plage sont généralement rencontrées.

De façon optionnelle également, les saillies présentent une hauteur d'au moins 1 mm, de préférence d'au moins 2 mm. Ainsi, l'échange thermique est favorisé.

De façon optionnelle également, les saillies comportent des ailettes et/ou des pions. Ces formes de saillies présentent des formes complémentaires simple à réaliser dans la plaque froide.

De façon optionnelle également, les saillies sont réalisées par fabrication additive. Cette méthode de fabrication est simple à mettre en œuvre et est particulièrement adaptée pour la fabrication d'ailettes et/ou de pions.

De façon optionnelle également, le module électrique de puissance comporte un substrat comprenant une plaque isolante et, sur une face inférieure de la plaque isolante, une couche inférieure formant au moins en partie le radiateur.

De façon optionnelle également, le système électrique comporte en outre :
- une pompe hydraulique ;
- un canal aller depuis la pompe hydraulique jusqu'à une entrée de la boîte à eau ; et
- un canal retour depuis une sortie de la boîte à eau jusqu'à la pompe hydraulique.

Il est également proposé un aéronef comportant un système électrique selon l'invention.

Il est également proposé un procédé de fabrication d'un système électrique selon l'invention, comportant :
- le remplissage partiel des cavités par le métal liquide ; et
- l'insertion des saillies dans les cavités, de sorte que les saillies poussent le métal liquide pour faire monter ce dernier dans les cavités, de préférence pour l'en faire sortir de manière à remplir un interstice présent entre le radiateur et la plaque froide, en dehors des cavités et des saillies.

### Brève description des figures

L'invention sera mieux comprise à l'aide de la description qui va suivre, donnée uniquement à titre d'exemple et faite en se référant aux dessins annexés dans lesquels :
la [Fig. 1] est une vue en coupe d'un système électrique selon l'invention,
la [Fig. 2] est un schéma bloc d'un procédé de fabrication d'un système électrique tel que celui de la figure 1,
la [Fig. 3] est une vue similaire à celle de la figure 1, illustrant une étape intermédiaire de fabrication,
la [Fig. 4] est une vue similaire à celle de la figure 1, illustrant une étape intermédiaire de fabrication, et
la [Fig. 5] est une photographie de différents types de saillies pouvant être utilisés.

### Description détaillée de l'invention

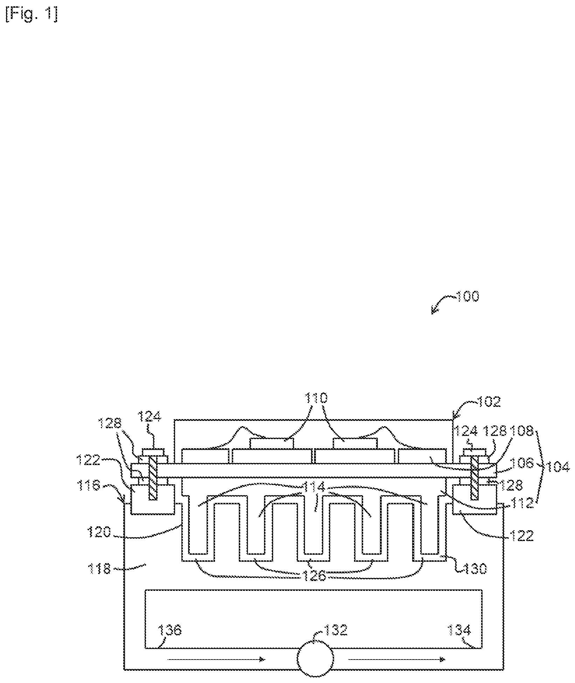

En référence à la figure 1, un exemple d'un système électrique 100 d'un aéronef, dans lequel l'invention est mise en œuvre, va à présent être décrit.

Le système électrique 100 comporte tout d'abord un module électrique de puissance 102.

Le module électrique de puissance 102 comporte un substrat 104 comprenant, par exemple, une plaque intermédiaire 106 isolante électrique et une couche supérieure 108 conductrice électrique s'étendant sur une face supérieure de la plaque intermédiaire 106.

Le module électrique de puissance 102 comporte au moins un composant électrique 110 monté sur la couche supérieure 108 du substrat 104. Chaque composant électrique 110 est ainsi porté mécaniquement par cette couche supérieure 108 et connecté électriquement à cette couche supérieure 108.

Le module électrique de puissance 102 comporte en outre un radiateur 112, généralement en métal conducteur électrique, s'étendant sur une face inférieure de la plaque intermédiaire 106.

Par exemple, le substrat 104 peut être à cuivre directement lié (de l'anglais « Direct Bonded Copper », également désigné par l'acronyme DBC). Dans ce cas, la plaque intermédiaire 106 est en céramique, tandis que la couche supérieure 108 est en cuivre, de même qu'une couche inférieure formant au moins en partie de radiateur 112.

Alternativement, le radiateur pourrait être formé d'une plaque de base, par exemple en cuivre ou en aluminium, rapportée sur le substrat 104, par exemple sur la couche inférieure en cuivre dans le cas d'un substrat DBC.

Le radiateur 112 présente des saillies 114 de dissipation thermique, comme des ailettes ou des pions, se projetant vers le bas. De préférence, ces saillies 114 sont réalisées par fabrication additive à partir d'une plaque initiale du radiateur 112, par exemple comme cela est décrit dans la demande internationale publiée sous le numéro WO 2020 021197 A1.

Cette plaque initiale comporte par exemple la couche inférieure en cuivre dans le cas d'un substrat DBC. La fabrication des saillies 114 directement sur la couche inférieure du substrat 104 permet de réduire la résistance thermique et donc d'augmenter les performances thermiques.

Les saillies 114 présentent une hauteur d'au moins 1 mm, de préférence d'au moins 2 mm, et pouvant aller jusqu'à 2 cm, voire plus.

Le système électrique 100 comporte en outre un système de refroidissement 116 du module électrique de puissance 102. Le système de refroidissement 116 utilise un fluide caloporteur, de préférence un liquide caloporteur. Dans la suite de la description, ce fluide caloporteur est décrit comme de l'eau, mais d'autres fluides caloporteurs pourraient être utilisés.

Ainsi, le système de refroidissement 116 comporte une boîte à eau 118 présentant une plaque 120 dite froide car refroidie par l'eau circulant dans la boîte à eau 118. La plaque froide 120 est conçue pour recevoir le module de puissance 102. Pour cela, la plaque froide 120 présente par exemple des supports 122 de réception du substrat 104, par exemple de la plaque intermédiaire 106. Le module de puissance 102 est par exemple fixé à la plaque froide 120 au moyen de vis de fixation 124, par exemple traversant la plaque intermédiaire 106 et les supports 122.

Pour favoriser la dissipation de chaleur, la plaque froide 120 présente des cavités 126 complémentaires des saillies 114. Ainsi, une fois le module de puissance 102 monté sur la plaque froide 120, le radiateur 112 se trouve en vis-à-vis de la plaque froide 120, avec les saillies 114 reçues dans les cavités 126. La surface d'échange thermique s'en trouve largement augmentée.

Il est en outre prévu un interstice entre le module de puissance 102 monté sur le système de refroidissement 116 et la plaque froide 120. En particulier, l'interstice est présent entre le radiateur 112 et la plaque froide 120, notamment au niveau des cavités 126 et des saillies 114. L'interstice est de préférence supérieur à 100 µm et/ou de préférence inférieur à 1 mm, en particulier entre les cavités 126 et les saillies 114.

Pour assurer l'étanchéité de l'interstice, des joints d'étanchéité 128 sont par exemple prévus, en particulier entre les supports 122 et la plaque intermédiaire 106 et/ou entre la plaque intermédiaire 106 et des têtes des vis de fixation 124. Ces joints d'étanchéité 128 permettent en outre une absorption des déformations du métal liquide 130, en dilation et en compression avec la température.

Pour améliorer la conduction de chaleur entre le radiateur 112 (et en particulier les saillies 114 et la plaque froide 120, le système électrique 100 comporte en outre du métal liquide 130 remplissant l'interstice, de préférence en totalité pour éviter que des bulles d'air ne se forment. En effet, ces dernières risqueraient de dégrader la performance de l'échange thermique. Le métal liquide 130 est notamment présent entre les saillies 114 et les cavités 122 les recevant.

Le métal liquide 130 présente de préférence une bonne conductivité thermique, par exemple supérieure à 50 W/m·K. Le métal liquide 130 reste de préférence liquide entre -20°C et 150°C, ce qui correspond à la plage de températures habituelle de fonctionnement d'un aéronef. Le métal liquide 130 présente par exemple une viscosité dynamique d'au moins 1 mPa.s à 20°C.

À titre d'exemple de métal liquide, on peut citer le Galinstan (Gallium-Indium-Stannum), à base d'un alliage de Gallium, Indium et d'étain. Le Galinstan un métal liquide à température ambiante. Sa température de fusion est à -19°C. En outre, le Galinstan présente une conductivité thermique de 73W/m·K, largement supérieure à celle des interfaces thermiques traditionnelles (5W/m·K), et sa viscosité dynamique est de 2,4 mPa.s à 20°C.

D'autres métaux liquides peuvent convenir. On peut notamment et non limitativement utiliser des alliages de Gallium, Indium et étain, avec différentes proportions des éléments, du Gallium pur, ou encore des alliages de Gallium et d'étain.

Pour éviter toute réaction entre le métal liquide 130 et le radiateur 112 de préférence réalisé en cuivre ou en aluminium, le Gallium étant par exemple hautement réactif avec l'aluminium, on prévoit avantageusement de réaliser un plaquage nickel du radiateur 112, typiquement par dépôt électrochimique.

Pour assurer une circulation du fluide caloporteur, de l'eau par exemple, dans la boîte à fluide caloporteur 118 et en particulier au contact de la plaque froide 120, le système de refroidissement 116 comporte en outre un circuit par exemple étanche de circulation du fluide caloporteur. Ce circuit comporte par exemple et de manière classique une pompe hydraulique 132, un canal aller 134 depuis la pompe hydraulique 132 jusqu'à une entrée de la boîte à eau 118 et un canal retour 136 depuis une sortie de la boîte à eau 118 jusqu'à la pompe hydraulique 132.

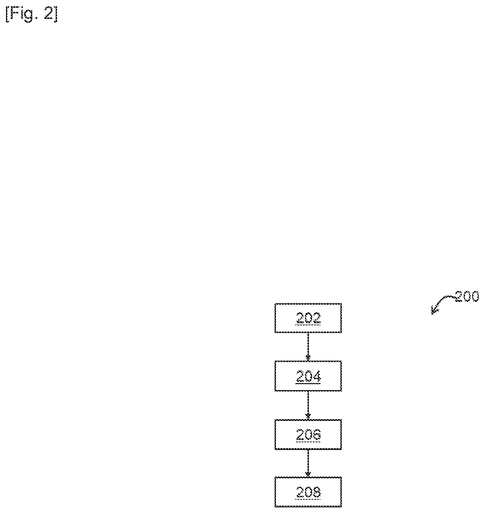

En référence aux figures 2 à 4, un exemple de procédé 200 de fabrication d'un système électrique tel que celui de la figure 1, va à présent être décrit.

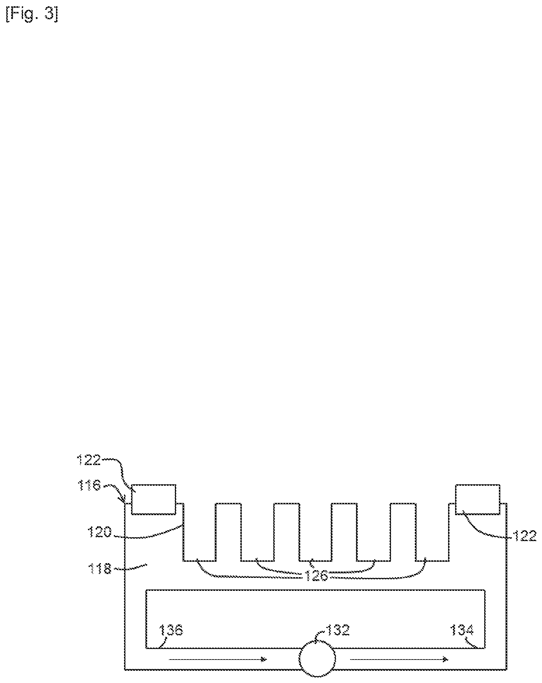

Au cours d'une étape 202, le système de refroidissement 116 avec la plaque froide 120 selon l'invention est obtenu. Le résultat de cette étape est par exemple illustré sur la figure 3.

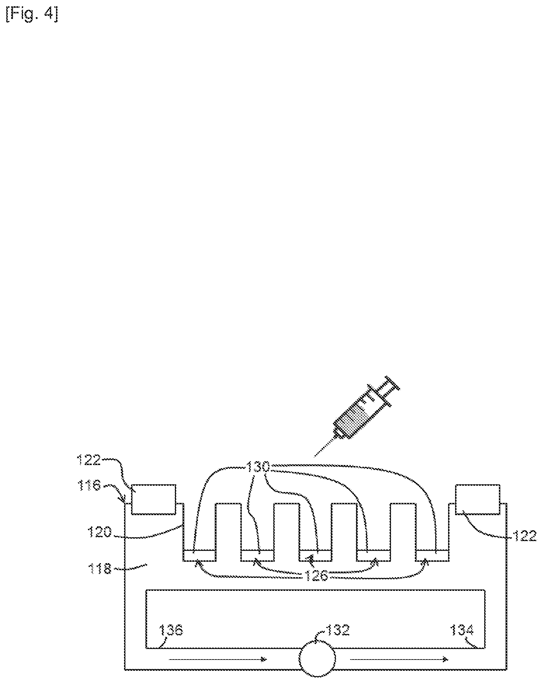

Au cours d'une étape 204, les cavités 126 de la plaque froide 120 sont remplies partiellement par le métal liquide 130. Généralement, quelques gouttes suffisent. Le résultat de cette étape est par exemple illustré sur la figure 4.

Au cours d'une étape 206, un module de puissance, tel que le module de puissance 102 illustré sur la figure 1, est monté sur le système de refroidissement 116. Lors de cette étape, les saillies 114 entrent dans les cavités 126 et poussent le métal liquide pour faire monter ce dernier dans les cavités et sortir des cavités, afin qu'il remplisse l'interstice. Avantageusement, on s'assure de remplir entièrement le volume de l'interstice de manière à garantir des propriétés de refroidissement thermique optimales, en prévoyant un volume de métal liquide supérieure au volume de l'interstice. Connaissant le volume de l'interstice, il est facile de doser le volume adéquat de métal liquide à injecter dans les cavités 126 au cours de l'étape 204, au moyen typiquement d'une seringue graduée.

Au cours d'une étape 208, le module de puissance 102 est fixé au système de refroidissement 116, par exemple au moyen des vis de fixation 124. Le résultat de cette étape est par exemple le système électrique 100 illustré sur la figure 1.

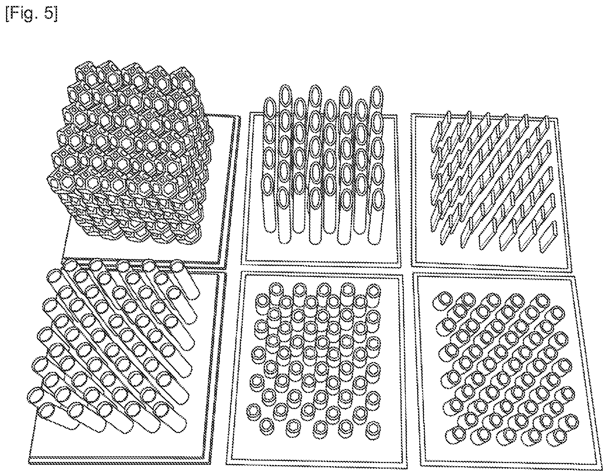

La figure 5 présente différentes formes que les saillies 114 peuvent revêtir.

En conclusion, il apparaît clairement qu'un système électrique tel que celui décrit précédemment permet d'assembler un module de puissance à refroidir, sur une plaque froide, complètement étanche, ne nécessitant pas de purge du système de refroidissement. Ceci est particulièrement avantageux lorsque le module de puissance est utilisé dans un aéronef, où l'intégration croissante de l'électronique de puissance rend difficile le démontage du système de refroidissement.

## Revendications

1. Système électrique (100) d'un aéronef, comportant :
- un module électrique de puissance (102) comportant un radiateur (112) muni de saillies (114) de dissipation thermique ; et
- une plaque froide (120) d'une boîte à fluide caloporteur (118), présentant des cavités (126) complémentaires des saillies (114) pour recevoir ces dernières ;
**caractérisé en ce que** du métal liquide (130) est intercalé entre le radiateur (112) et la plaque froide (120), au moins entre les saillies (114) et les cavités (126).

2. Système électrique selon la revendication 1, dans lequel le métal liquide (130) présente une conductivité thermique supérieure à 50 W/m·K.

3. Système électrique selon la revendication 1 ou 2, dans lequel le métal liquide (130) reste liquide entre -20°C et 150°C.

4. Système électrique selon l'une quelconque des revendications 1 à 3, dans lequel les saillies (114) présentent une hauteur d'au moins 1 mm, de préférence d'au moins 2 mm.

5. Système électrique selon l'une quelconque des revendications 1 à 4, dans lequel les saillies (114) comportent des ailettes et/ou des pions.

6. Système électrique selon l'une quelconque des revendications 1 à 5, dans lequel les saillies (114) sont réalisées par fabrication additive.

7. Système électrique selon l'une quelconque des revendications 1 à 6, dans lequel le module électrique de puissance (102) comporte un substrat (104) comprenant une plaque isolante (106) et, sur une face inférieure de la plaque isolante (106), une couche inférieure formant au moins en partie le radiateur (112).

8. Système électrique selon l'une quelconque des revendications 1 à 7, comportant en outre :
- une pompe hydraulique (132) ;
- un canal aller (134) depuis la pompe hydraulique (132) jusqu'à une entrée de la boîte à eau (118) ; et
- un canal retour (136) depuis une sortie de la boîte à eau (118) jusqu'à la pompe hydraulique (132).

9. Aéronef comportant un système électrique (100) selon l'une quelconque des revendications 1 à 8.

10. Procédé (200) de fabrication d'un système électrique (100) selon l'une quelconque des revendications 1 à 8, comportant :
- le remplissage (204) partiel des cavités (126) par le métal liquide (130) ; et
- l'insertion (206) des saillies (114) dans les cavités (126), de sorte que les saillies (114) poussent le métal liquide (130) pour faire monter ce dernier dans les cavités (126), de préférence pour l'en faire sortir de manière à remplir un interstice présent entre le radiateur (112) et la plaque froide (120), en dehors des cavités (126) et des saillies (114).

## Patentansprüche

1. Elektrisches System (100) eines Luftfahrzeugs, umfassend:
- ein elektrisches Leistungsmodul (102), umfassend eine mit Vorsprüngen (114) zur Wärmeableitung ausgestattete Heizung (112); und
- eine Kühlplatte (120) eines Wärmeträgerfluidkastens (118), die Hohlräume (126) aufweist, die zu den Vorsprüngen (114) komplementär sind, um letztere aufzunehmen;
**dadurch gekennzeichnet, dass** flüssiges Metall (130) zwischen der Heizung (112) und der Kühlplatte (120), mindestens zwischen den Vorsprüngen (114) und den Hohlräumen (126), interkaliert ist.

2. Elektrisches System nach Anspruch 1, wobei das flüssige Metall (130) eine Wärmeleitfähigkeit von größer als 50 W/m-K aufweist.

3. Elektrisches System nach Anspruch 1 oder 2, wobei das flüssige Metall (130) zwischen -20 °C und 150 °C flüssig bleibt.

4. Elektrisches System nach einem der Ansprüche 1 bis 3, wobei die Vorsprünge (114) eine Höhe von mindestens 1 mm, vorzugsweise von mindestens 2 mm aufweisen.

5. Elektrisches System nach einem der Ansprüche 1 bis 4, wobei die Vorsprünge (114) Rippen und/oder Stifte umfassen.

6. Elektrisches System nach einem der Ansprüche 1 bis 5, wobei die Vorsprünge (114) durch additive Fertigung hergestellt werden.

7. Elektrisches System nach einem der Ansprüche 1 bis 6, wobei das elektrische Leistungsmodul (102) ein Substrat (104) umfasst, das eine Isolierplatte (106) und auf einer unteren Fläche der Isolierplatte (106) eine untere Schicht beinhaltet, die mindestens zum Teil die Heizung (112) bildet.

8. Elektrisches System nach einem der Ansprüche 1 bis 7, weiter umfassend:
- eine Hydraulikpumpe (132);
- einen Vorwärtskanal (134) ab der Hydraulikpumpe (132) bis zu einem Eingang des Wasserkastens (118); und
- einen Rückkanal (136) ab einem Ausgang des Wasserkastens (118) bis zu der Hydraulikpumpe (132).

9. Luftfahrzeug, das ein elektrisches System (100) nach einem der Ansprüche 1 bis 8 umfasst.

10. Verfahren (200) zur Anfertigung eines elektrischen Systems (100) nach einem der Ansprüche 1 bis 8, umfassend
- die teilweise Befüllung (204) der Hohlräume (126) durch das flüssige Metall (130); und
- die Einführung (206) der Vorsprünge (114) in die Hohlräume (126) derart, dass die Vorsprünge (114) das flüssige Metall (130) drücken, um letzteres in die Hohlräume (126) steigen zu lassen, vorzugsweise, um es auf eine Art austreten zu lassen, um einen Zwischenraum zu füllen, der zwischen der Heizung (112) und der Kühlplatte (120), außerhalb der Hohlräume (126) und der Vorsprünge (114), vorhanden ist.

## Claims

1. An electrical system (100) for an aircraft, comprising:
- an electrical power module (102) comprising a heat sink (112) provided with thermal dissipation projections (114); and
- a cold plate (120) of a heat transfer fluid box (118), having cavities (126) complementary to the projections (114) for receiving the latter;
**characterised in that** liquid metal (130) is interposed between the heat sink (112) and the cold plate (120), at least between the projections (114) and the cavities (126).

2. The electrical system of claim 1, wherein the liquid metal (130) has a thermal conductivity greater than 50 W/m·K.

3. The electrical system according to claim 1 or 2, wherein the liquid metal (130) remains liquid between -20°C and 150°C.

4. The electrical system according to any one of claims 1 to 3, wherein the projections (114) have a height of at least 1 mm, preferably at least 2 mm.

5. The electrical system according to any one of claims 1 to 4, wherein the projections (114) comprise fins and/or pins.

6. The electrical system according to any one of claims 1 to 5, wherein the projections (114) are made by additive manufacturing.

7. The electrical system according to any one of claims 1 to 6, wherein the electrical power module (102) comprises a substrate (104) comprising an insulating plate (106) and, on a lower face of the insulating plate (106), a lower layer forming at least in part the heat sink (112).

8. The electrical system according to any one of claims 1 to 7, further comprising:
- a hydraulic pump (132);
- a forward channel (134) from the hydraulic pump (132) to an inlet of the water box (118); and
- a return channel (136) from an outlet of the water box (118) to the hydraulic pump (132).

9. An aircraft comprising an electrical system (100) according to any one of claims 1 to 8.

10. A method (200) of manufacturing an electrical system (100) according to any one of claims 1 to 8, comprising :
- partial filling (204) of the cavities (126) with liquid metal (130); and
- inserting (206) the projections (114) into the cavities (126), so that the projections (114) push the liquid metal (130) upwards into the cavities (126), preferably out so as to fill a gap between the heat sink (112) and the cold plate (120) outside the cavities (126) and the projections (114).
